Europäisches Patentamt

European Patent Office

Office européen des brevets

(11) Numéro de publication: **0 351 331**
**A1**

## (12) DEMANDE DE BREVET EUROPEEN

(21) Numéro de dépôt: **89420246.4**

(22) Date de dépôt: **10.07.89**

(51) Int. Cl.5: **H 01 L 21/76**

(30) Priorité: **13.07.88 FR 8809848**

(43) Date de publication de la demande:
**17.01.90 Bulletin 90/03**

(84) Etats contractants désignés: **DE FR GB IT NL**

(71) Demandeur: **SGS-THOMSON MICROELECTRONICS S.A.**
**7, Avenue Galliéni**
**F-94250 Gentilly (FR)**

(72) Inventeur: **Tonnel, Eugène**
**6, Impasse Bérivière**
**F-38240 Meylan (FR)**

(74) Mandataire: **de Beaumont, Michel**
**1bis, rue Champollion**
**F-38000 Grenoble (FR)**

(54) **Structure de circuit intégré améliorant l'isolement entre composants.**

(57) La présente invention concerne une structure de circuit intégré dans laquelle chaque composant élémentaire (1, 2, 3, 4) est formé à l'intérieur d'un caisson (10, 20, 30, 40) d'un premier type de conductivité formé sur la surface supérieure d'un substrat d'un deuxième type de conductivité et séparé des caissons adjacents par un mur d'isolement. Ledit substrat consiste en une plaquette semiconductrice du deuxième type de conductivité à haut niveau de dopage (50) dont la face supérieure comprend une couche du deuxième type de conductivité (51) à plus faible niveau de dopage, les murs d'isolement traversant ladite couche du deuxième type de conductivité pour rejoindre le substrat.

Figure 2

EP 0 351 331 A1

Description

## STRUCTURE DE CIRCUIT INTÉGRÉ AMÉLIORANT L'ISOLEMENT ENTRE COMPOSANTS

La présente invention concerne une nouvelle structure de circuit intégré améliorant l'isolement entre composants et plus particulièrement une structure comprenant des composants de puissance et permettant d'améliorer l'isolement de ces composants de puissance.

La réalisation de circuits intégrés de puissance tels que les commandes de moteurs conduit à l'intégration de plusieurs transistors de puissance, bipolaires ou à effet de champ, isolés sur la même pastille.

Ces transistors suivant les conditions d'utilisation peuvent fonctionner à courant élevé à des instants différents ; selon leurs dimensions, leurs dispositions et leurs polarités respectives, ils peuvent donner naissance à des courants élevés dans le substrat et déclencher le fonctionnement de transistors parasites dont le gain peut être assez élevé pour conduire à la destruction du circuit.

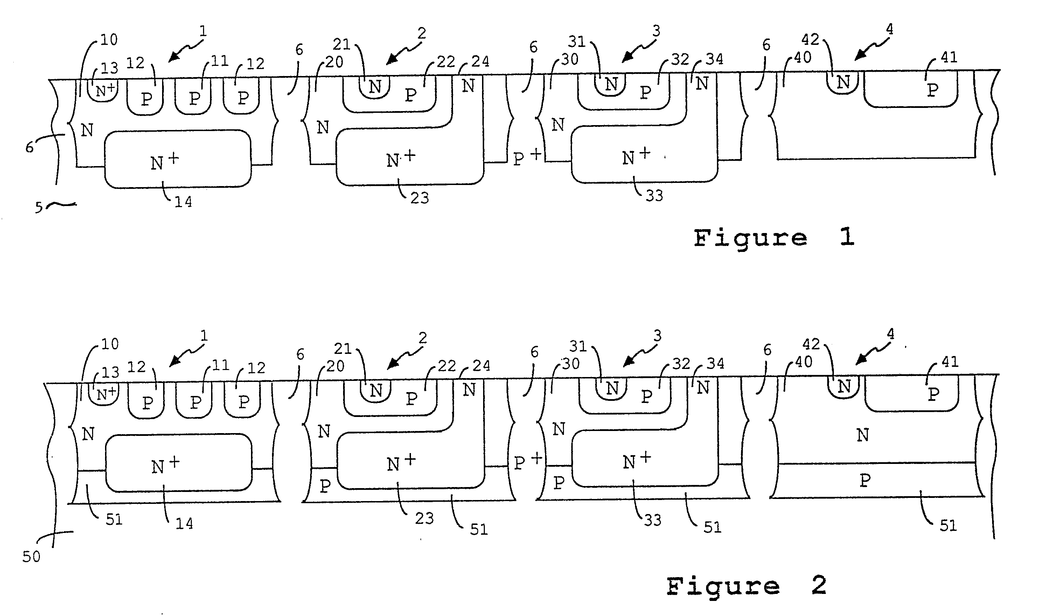

La figure 1 représente une structure de circuit intégré classique dans laquelle on a indiqué, en vue en coupe et de façon schématique, quelques composants particuliers. La référence 1 désigne un transistor PNP latéral, les références 2 et 3 des transistors de puissance NPN verticaux, et la référence 4 un transistor PNP substrat. Ces différents composants sont formés dans des caissons de type N 10, 20, 30 et 40 eux-mêmes formés dans un substrat 5 de type P et isolés latéralement par des murs 6 de type P+. Le transistor PNP latéral 1 est constitué d'une zone émetteur 11 de type P entourée par un collecteur 12 de type P. Le contact de base 13 de type N est à l'extérieur du collecteur pour éviter la recombinaison dans la base active. De plus, une couche enterrée 14 est prévue pour réduire la fuite des trous vers le substrat. Les transistors NPN verticaux 2 et 3 comprennent respectivement une zone d'émetteur 21, 31, une zone de base 22, 32, et une zone de collecteur constituée par le corps du caisson 20, 30, une zone de reprise de collecteur résultant d'une couche enterrée 23, 33, et un puits collecteur 24, 34 de type N+. Le transistor PNP substrat 4 comprend une zone d'émetteur de type P 41, une zone de reprise de contact de base 42 et son collecteur est constitué par le substrat 5.

Dans une telle structure, les collecteurs 23, 33 des transistors de puissance 2 et 3 contigus vont, selon leur état de polarisation, jouer le rôle d'émetteur et de collecteur d'un transistor NPN latéral parasite dont la base est formée par les régions d'isolement 6 et le substrat 5.

Le contrôle du gain de ce transistor parasite à une valeur suffisamment faible est nécessaire pour limiter son influence et obtenir un fonctionnement normal et fiable du circuit.

Deux solutions sont actuellement utilisées à cette fin.

- La première consiste à réduire la durée de vie des porteurs dans les différentes régions de ce transistor en utilisant, par exemple, un bombardement par des électrons ou des protons de forte énergie (2MeV). Bien que facile à contrôler, ce procédé ne permet pas d'obtenir un contrôle sélectif des différentes régions et il en résulte également une réduction du gain des transistors actifs, particulièrement des transistors PNP latéral (1) et substrat (4), dont la base peu dopée est particulièrement sensible aux défauts créés par le bombardement.

Le dopage avec une impureté tuant la durée de vie, telle que l'or ou le platine conduirait aux mêmes résultats et aurait les mêmes inconvénients que précédemment.

- La deuxième solution, dont un exemple est décrit dans le brevet américain 4 466 011 (Van Zanten), consiste à utiliser un caisson de garde entourant le caisson à isoler et collectant les courants parasites qui pourraient être émis par le caisson central lorsque ce dernier joue le rôle d'émetteur. Cette deuxième solution permet de garder des caractéristiques correctes pour les transistors PNP latéraux et verticaux. Cependant, la disposition de ce caisson enveloppant à la périphérie des éléments critiques est exigeante en surface et le contrôle des courants parasites et du gain des transistors NPN latéraux entre caissons devient de plus en plus inefficace lorsque les tensions et les puissances mises en jeu dans les circuits intégrés augmentent. En effet plus les puissances et les tensions de fonctionnement augmentent, plus il est nécessaire d'utiliser des substrats de résistivité élevée.

Il est courant d'utiliser des substrats d'une résistivité de 10 à 20 ohms.cm. La réduction de la recombinaison et l'augmentation des longueurs de diffusion des porteurs qui en résultent se manifestent par une augmentation du gain du transistor NPN latéral parasite et par une fraction de plus en plus grande de courant dépassant la région du caisson collectant.

Ces porteurs diffusent profondément dans le substrat et peuvent être collectés par des caissons éloignés de la diode émettrice et ceci d'autant plus loin que le dispositif devant tenir des tensions élevées est formé sur un substrat de résistivité élevée.

Ainsi, un objet de la présente invention est de prévoir une nouvelle structure de circuit intégré améliorant l'isolement entre composants de puissance dans laquelle le fond de chaque caisson contenant un composant, isolé latéralement, diélectriquement ou par jonction, des autres caissons, repose sur une couche supplémentaire de type de conductivité opposé à celui du caisson formé sur un substrat du même type de conductivité et à fort niveau de dopage.

Ainsi, grâce à la couche supplémentaire du deuxième type de conductivité interposée entre le substrat proprement dit à haut niveau de dopage et le caisson du type de conductivité opposé, on assure un isolement satisfaisant de chacune des jonctions et des caractéristiques convenables pour les transistors verticaux tels que les transistors PNP substrats décrits précédemment mais on évite la formation de transistors parasites entre couches enterrées de fonds de caissons car la base de tels transistors comprendra nécessairement une région isolante ou une région de haut niveau de dopage dans laquelle la durée de vie des porteurs est faible.

Ces objets, caractéristiques et avantages ainsi que d'autres de la présente invention seront exposés plus en détail dans la description suivante d'un mode de réalisation particulier dans laquelle :

La figure 1, déjà décrite, représente une structure classique de circuit intégré bipolaire à isolement par jonction ;

La figure 2 représente une structure analogue à celle de la figure 1 modifiée selon la présente invention ;

les figures 3A à 3D illustrent de étapes de fabrication d'une structure selon la présente invention ; et

la figure 4 représente une variante d'une étape de fabrication d'une structure selon la présente invention.

De façon générale, et comme cela cela est classique dans la représentation des circuits intégrés, on notera que les diverses figures ne sont pas représentées à l'échelle ni d'une figure à l'autre ni à l'intérieur d'une même figure et notamment que les épaisseurs des couches sont dessinées arbitrairement dans le but de faciliter la lecture des figures.

La figure 2 représente un exemple de parties de circuits intégrés bipolaires et est identique à la figure 1 en ce qui concerne les composants formés dans les divers caissons 10, 20, 30 et 40. Dans ces deux figures, de mêmes éléments et couches sont désignés par de mêmes références numériques.

A la figure 2, à la différence de la figure 1, les divers caissons, au lieu d'être formés sur un substrat de type P de faible niveau de dopage présentant par exemple une résistivité de 10 à 20 ohms par centimètre comme cela a été indiqué précédemment, sont formés dans un substrat composé d'une zone principale 50 fortement dopée de type P$^+$ revêtue d'une couche 51 de type P. Cette couche 51 présente un niveau de dopage équivalent à celui du substrat 5 de type P de la figure 1 pour obtenir des caractéristiques de tenue en tension similaires, notamment en ce qui concerne la jonction avec les couches 23 et 33 des transistors de puissance 2 et 3 et la jonction base/collecteur du transistor PNP substrat 4. On notera que les murs 6 de type P$^+$ à haut niveau de dopage traversent la couche P 51 pour rejoindre le substrat 50 de type P$^+$.

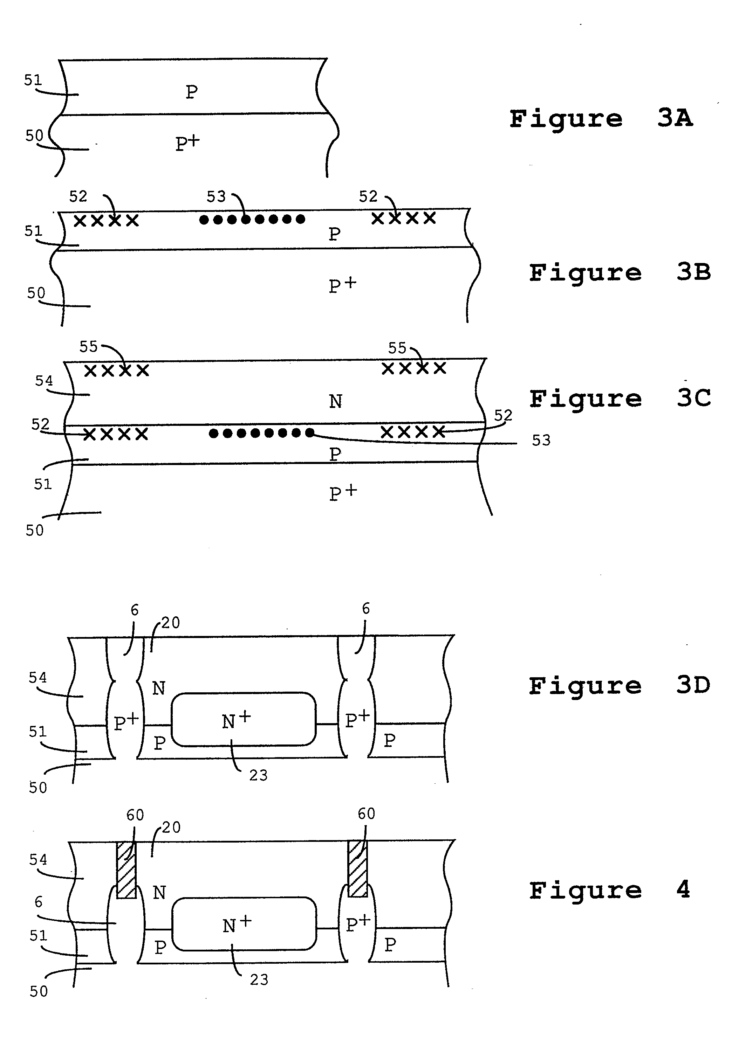

Des étapes de fabrication possibles d'un mode de réalisation de la présente invention sont illustrées en figures 3A à 3D.

La figure 3A représente un substrat 50 de type P$^+$ sur lequel est formée une couche épitaxiée 51 de type P.

A la figure 3B, on a représenté la même structure qu'en figure 3A avec des zones marquées de croix 52 consistant en des implantations de fondation de dopant de type P qui entourent complètement chacun des caissons qui seront ultérieurement formés. Au fond de certains caissons, dans lesquels on veut former des couches enterrées, on réalise une implantation 53 de type N désignée par des points.

Ensuite, comme le représente la figure 3C, on forme au-dessus de la couche de type P 51 une couche épitaxiée de type N 54. Il est d'ailleurs possible qu'au cours de la formation de cette couche épitaxiée, les implantations 52 et 53 commencent à diffuser.

On a également représenté à la figure 3C, des zones d'implantation 55 de type P en regard des zones d'implantation de fondation 52.

La figure 3D représente la structure de la figure 3C après traitement thermique. Les zones implantées 52, 53 et 55 diffusent pour former les murs d'isolement 6 délimitant un caisson, par example le caisson 20 des figures 1 et 2 au fond duquel est formée la couche enterrée 23.

Les autres étapes de fabrication pour passer de la figure 3D à la figure 2 sont des étapes classiques (on notera que dans le cas où l'on forme des puits collecteurs 24, 34, on réalisera pour ces puits des implantations superficielles de type N à l'étape illustrée en figure 3C).

Ainsi, en revenant sur la figure 2, on notera que la structure particulière de substrat utilisée permet de former au fond de chaque caisson des régions 51 de type P entourées de régions P$^+$ (substrat 50 et murs d'isolement 6). Ces régions P$^+$ interdisent la diffusion des porteurs, électrons dans ce cas, entre les deux régions N$^+$ que constituent les collecteurs 23, 33 des transistors de puissance NPN voisins 2, 3. Il est alors possible par une définition optimale du dopage et des dimensions relatives des régions P 51 et P$^+$ 6 et 50 d'assurer simultanément la tenue en tension requise pour la diode d'isolement du collecteur des transistors NPN, diode N$^+$P 23 - 51, et le contrôle de la contribution du substrat avec celui du dopage P$^+$ de la base dans le fonctionnement du transistor NPN latéral parasite inter-caissons.

Le fonctionnement de la partie de ce transistor latéral parasite NPN formée dans la couche épitaxiée 54 est également contrôlé par le dopage de sa base constituée par les régions P$^+$ formant les fondations et les murs d'isolement inter-caisson. L'épaisseur et le dopage élevé de ces régions permet là aussi de réduire le gain inter-caisson en proportion.

La structure de substrat utilisée, couche épitaxiée P sur substrat P$^+$, permet de limiter la profondeur de diffusion des porteurs à la couche épitaxiée P, la pénétration des fondations d'isolement dans cette couche devant être suffisante pour en réduire le trajet latéral.

L'isolement utilisé pour former les caissons dans la couche épitaxiée N peut être du type à jonction diffusée comme donné à titre d'exemple dans le cas d'intégration de composants de puissance. Cependant la structure décrite est également bien adaptée à l'intégration de mémoires de grande capacité, bipolaires ou MOS. Dans ce cas l'isolement est réalisé soit par croissance d'oxyde localisé, soit par gravure et comblement de sillons effectués dans la couche épitaxiée de type N dans laquelle sont délimités les caissons 10, 20, 30 et 40.

Ainsi, la présente invention s'applique au cas où l'isolement entre les caissons est un isolement diélectrique latéral et la présente invention peut s'appliquer à l'intégration de mémoires de grande capacité de type bipolaire ou MOS. La structure proposée peut dans ce cas être mise en oeuvre pour réduire les courants de substrat et limiter par exemple les effets de proximité ou diaphonie entre points mémoire lors de la programmation de mémoires mortes bipolaires programmables de grande capacité (256 K) ou réduire l'influence des particules dans les mémoires MOS de type dynamique, pour améliorer par exemple l'immunité aux particules des mémoires de type DRAM à mémorisation capacitive et de grande capacité (1 à 16 Mbits).

La figure 4 illustre un exemple d'isolement mixte (bipolaire-diélectrique) entre caissons. La figure 4 reprend la même représentation que la figure 3D. Toutefois, les murs d'isolement sont réalisés dans leur partie inférieure par la diffusion de type P$^+$ résultant des fondations 52 illustrées en figure 3C et dans leur partie supérieure d'une rainure isolée 60. On pourrait envisager également des isolements complètement diélectriques à la condition que ces isolements diélectriques traversent la couche 51 pour rejoindre le substrat 50.

Dans ce qui précède on s'est toujours placé dans le cas de dispositifs réalisés sur substrat P. Il serait inversement possible de prévoir des structures réalisées sur substrat N, tous les types de conductivité étant alors interchangés.

**Revendications**

1. Structure de circuit intégré dans laquelle chaque composant élémentaire est formé à l'intérieur d'un caisson (10, 20, 30, 40) d'un premier type de conductivité formé sur la surface supérieure d'un substrat d'un deuxième type de conductivité et séparé des caissons adjacents par un mur d'isolement, ledit substrat consistant en une plaquette semiconductrice du deuxième type de conductivité à haut niveau de dopage (50) dont la face supérieure comprend une couche du deuxième type de conductivité (51) à plus faible niveau de dopage, caractérisée en ce que les murs d'isolement traversent ladite couche du deuxième type de conductivité pour rejoindre le substrat.

2. Structure de circuit intégré selon la revendication 1, caractérisée en ce que les murs d'isolement (6) sont constitués de zones dopées du deuxième type de conductivité.

3. Structure de circuit intégré selon la revendication 1, caractérisée en ce qu'elle comprend dans certains caissons au moins des transistors NPN de puissance (2, 3) dont les collecteurs correspondent à une couche enterrée (23, 33) du premier type de conductivité à haut niveau de dopage, le fond de ces couches enterrées étant entouré de ladite couche du deuxième type de conductivité (51) qui est choisie d'une épaisseur suffisante pour permettre une tenue en tension désirée.

4. Structure de circuit intégré selon la revendication 1, caractérisée en ce que la couche du deuxième type de conductivité (51) est formée sur le substrat (50) par épitaxie.

5. Structure de circuit intégré selon la revendication 4, caractérisée en ce que le matériau semiconducteur dans lequel sont délimités les caissons est une couche du premier type de conductivité formée par épitaxie sur ladite couche du deuxième type de conductivité (51).

EP 0 351 331 A1

Figure 1

Figure 2

**Figure 3A**

**Figure 3B**

**Figure 3C**

**Figure 3D**

**Figure 4**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | GB-A-2 183 907  (DAYTHEON CO.)<br>* Page 2, ligne 120 - page 5, ligne 103; page 5, lignes 109-116; figures 1B,2; page 6, lignes 1-3 * | 1,4,5 | H 01 L  21/76 |
| Y | --- | 2,3 | |
| Y | EP-A-0 057 549  (TOSHIBA K.K.)<br>* Figures 3G,4H; page 4, ligne 26 - page 6, ligne 6 * | 2,3 | |
| A | --- | 1,4,5 | |
| A | DE-A-2 952 318  (LICENTIA PATENT VERWALTUNGS-GmbH)<br>* Revendication 1; figure 2 *<br>----- | 1-5 | |

DOMAINES TECHNIQUES
RECHERCHES (Int. Cl.5)

H 01 L

Le présent rapport a été établi pour toutes les revendications

| Lieu de la recherche | Date d'achèvement de la recherche | Examinateur |
|---|---|---|
| LA HAYE | 10-10-1989 | GELEBART J.F.M. |